Europäisches Patentamt

European Patent Office

Office européen des brevets

(19)

(11) Veröffentlichungsnummer: **0 214 491**
**B1**

(12) # EUROPÄISCHE PATENTSCHRIFT

(45) Veröffentlichungstag der Patentschrift:
28.03.90

(51) Int. Cl.⁴: **H03G 3/20, H03D 7/00**

(21) Anmeldenummer: 86111192.0

(22) Anmeldetag: 13.08.86

(54) **Batterie- oder akkumulatorbetriebener Funkempfänger.**

(30) Priorität: 07.09.85 DE 3531961

(43) Veröffentlichungstag der Anmeldung:
18.03.87 Patentblatt 87/12

(45) Bekanntmachung des Hinweises auf die Patenterteilung:
28.03.90 Patentblatt 90/13

(84) Benannte Vertragsstaaten:
CH DE GB LI NL

(56) Entgegenhaltungen:
EP-A- 0 016 705
US-A- 3 457 514
US-A- 3 886 452
US-A- 4 355 414

FUNKSCHAU, Heft 8, 1977, Seiten 333-336, München,
DE; E. KOCH: "200-Kanal-Handsprechfunkgerät für
das 2-m-Band"

(73) Patentinhaber: ROBERT BOSCH GMBH, Postfach 50,
D-7000 Stuttgart 1(DE)

(72) Erfinder: Härtel, Jörg, Treitschkestrasse 26,
D-1000 Berlin 41(DE)

(74) Vertreter: Schmidt, Hans-Ekhardt, Robert Bosch GmbH
Geschäftsbereich Elektronik Patent- und
Lizenzabteilung Forckenbeckstrasse 9-13,
D-1000 Berlin 33(DE)

## Beschreibung

### Stand der Technik

Die Erfindung geht von einem batterie- oder akkumulatorbetriebenen Funkempfänger nach der Gattung des Anspruchs 1 aus.

Es ist ein batteriebetriebener Funkempfänger bekannt (Funkschau, 1977, Heft 8, Seiten 333 ... 336), bei dem das Problem der Interkanalmodulationsfestigkeit durch Verwendung eines Ringmischers gelöst wird; jedoch ist es bisher nicht gelungen, eine hohe Interkanalmodulationsfestigkeit bei verhältnismäßig geringer Leistungsaufnahme des Funkempfängers zu erzielen.

### Vorteile der Erfindung

Der erfindungsgemäße batteriebetriebene Funkempfänger mit den kennzeichnenden Merkmalen des Anspruchs 1 hat den Vorteil, daß der für eine hohe Interkanalmodulationsfestigkeit benötigte hohe Oszillatorpegal für den Mischer nur dann bereitgestellt wird, wenn es die Empfangssituation erfordert. Dadurch wird die Betriebsdauer eines aus Batterien oder Akkumulatoren gespeisten Funkempfängers erhöht. Durch die in den Unteransprüchen aufgeführten Maßnahmen sind vorteilhafte Weiterbildungen und Verbesserungen des im Anspruch 1 angegebenen batteriebetriebenen Funkempfängers möglich. Besonders vorteilhaft ist ein erfindungsgemäßer Funkempfänger, bei dem eine Mikroprozessorschaltung oder ein Zeitschaltkreis vorgesehen ist, der den Oszillatorpegel in zyklischen Zeitabständen auf den normalen Oszillatorpegel schaltet. Auf diese Weise werden die die Interkanalmodulationsfestigkeit bestimmenden Kriterien laufend überwacht.

### Zeichnung

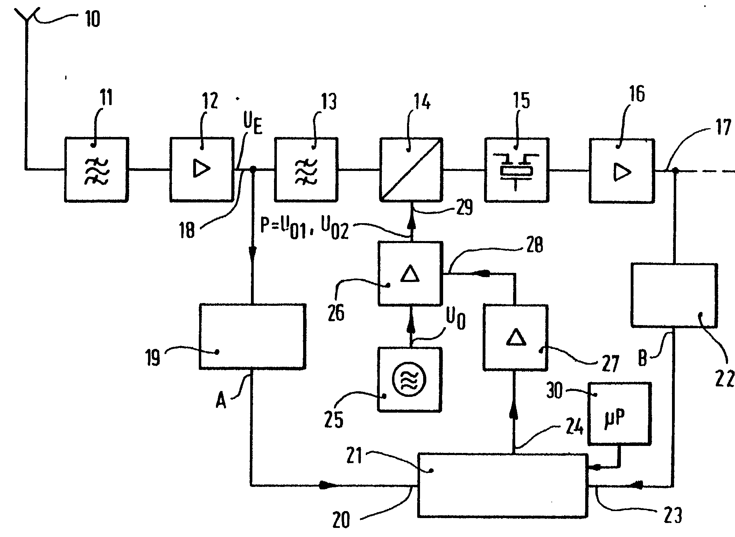

Ein Ausführungsbeispiel der Erfindung ist in der Zeichnung an Hand einer Figur dargestellt und in der nachfolgenden Beschreibung näher erläutert. Die Figur zeigt ein Blockschaltbild von Hochfrequenz- und Zwischenfrequenzteil eines erfindungsgemäßen Funkempfängers.

### Beschreibung der Erfindung

In der Zeichnung bezeichnet 10 eine Funkempfangsantenne eines batterie- oder akkumulatorbetriebenen Funkempfängers. Die Funkempfangsantenne ist mit dem Eingang eines Bandpaßfilters 11 verbunden. Auf das Bandpaßfilter folgt ein Hochfrequenzvorverstärker 12, von dessen Ausgang 18 zwei Wege abzweigen. Ein erster Weg führt über ein weiteres Bandpaßfilter 13 an einen Mischer 14, dessen Ausgang über ein Zwischenfrequenzfilter 15, das ist vorzugsweise ein Quarzfilter, mit einem Zwischenfrequenzverstärker 16 verbunden ist. Ein zweiter Weg führt von dem Ausgang 18 des Hochfrequenzvorverstärkers 12 über einen Schwellwertschalter 19 an einen ersten Eingang 20 einer logischen Verknüpfungsschaltung 21, deren zweiter Eingang 23 mit dem Ausgang einer Rauschsperre 22 verbunden ist. Die Rauschsperre ist eingangsseitig an den Ausgang des ZF-Verstärkers 16 angeschlossen. Zu dem Mischer 14 gehört ein Oszillator 25, der über einen steuerbaren Oszillatorverstärker 26 mit einem Oszillatoranschluß 29 des Mischers 14 verbunden ist. Ein Ausgang 24 der logischen Verknüpfungsschaltung 21 ist über einen Schaltverstärker 27 mit einem Steuereingang 28 des steuerbaren Oszillatorverstärkers 26 verbunden. Die logische Verknüpfungsschaltung 21 steht außerdem mit einer Mikroprozessorschaltung 30 in Verbindung.

Die vorstehend beschriebene Schaltung arbeitet folgendermaßen.

Um die Interkanalmodulationsfestigkeit des Funkempfängers nur dann zu erhöhen, wenn es die Empfangssituation erfordert, werden die Empfangsfeldstärke bzw. der ihr proportionale Hochfrequenzpegel $U_E$ und das Rauschkriterium bewertet. Erreicht oder überschreitet der Hochfrequenzpegel $U_E$ am Ausgang 18 des Hochfrequenzvorverstärkers 12 einen an dem Schwellwertschalter 19 eingestellten Wert, dann gibt der Schwellwertschalter 19 ein zum Beispiel dem logischen Wert 1 entsprechendes Signal an den Eingang 20 der logischen Verknüpfungsschaltung 21 ab. Stellt gleichzeitig die Rauschsperre 22 fest, daß in dem Zwischenfrequenzsignal am Ausgang 17 des Zwischenfrequenzverstärkers 16 ein bestimmter Rauschgrenzwert unterschritten wird, so gibt sie ebenfalls ein dem logischen Wert 1 entsprechendes Signal ab. Beide Signale des logischen Wertes 1 werden in der logischen Verknüpfungsschaltung 21 derart miteinander verknüpft, daß die Verknüpfungsschaltung an ihrem Ausgang 24 ein dem logischen Wert 1 entsprechendes Signal abgibt. Dieses mit dem Verstärker 27 verstärkte Signal steuert den Oszillatorverstärker 26 derart, daß der Oszillatorpegel P von einem normalen Wert $U_{01}$ auf einen Wert $U_{02}$ ansteigt. Durch den höheren Oszillatorpegel bzw. den höheren Mischerstrom wird die Interkanalmodulation weitgehend unterdrückt.

Der vorstehend beschriebene Zustand bleibt solange aufrechterhalten, bis zu irgendeinem Zeitpunkt der hohe Hochfrequenzpegel am Antenneneingang bzw. der Pegel $U_E$ am Ausgang des Hochfrequenzvorverstärkers 12 zurückgeht. Dann kann keine Interkanalmodulation entstehen, und der Schwellwertschalter 19 sowie die Rauschsperre 22 geben je ein Signal ab, das dem logischen Wert O entspricht. Die Verknüpfungsschaltung 21 verknüpft die beiden Signale derart, daß am Ausgang 24 ebenfalls ein dem logischen Wert O entsprechendes Signal auftritt, welches über den Verstärker 27 den Oszillatorverstärker 26 derart umsteuert, daß der erhöhte Oszillatorpegel $U_{02}$ wieder auf den Normalpegel $U_{01}$ zurückgeht.

In der folgenden Tabelle sind die verschiedenen logischen Zustände gezeigt.

| Zustand | A | B | P |
|---------|---|---|---|
| 1 | 0 | 0 | 0 |
| 2 | 0 | 1 | 0 |
| 3 | 1 | 0 | 0 |
| 4 | 1 | 1 | 1 |
| 5 | 1 | 0 | 1 |
| 6 | 0 | 1 | 0 |

In der Tabelle bedeuten A den logischen Wert am Ausgang des Schwellwertschalters 19 (niedriger Pegel = 0, hoher Pegel = 1), B den logischen Wert am Ausgang der Rauschsperre 22 (Rauschunterdrückung kleiner als Grenzwert = 0, Rauschunterdrückung größer oder gleich Grenzwert = 1) und P den Oszillatorpegel (nicht erhöhter Oszillatorpegel $U_{01}$ = 0, erhöhter Oszillatorpegel $U_{02}$ = 1) bzw. den Mischerstrom.

Der Übergang vom Zustand 4 auf den Zustand 5 stellt die Betriebswerte nach der Oszillatorpegelerhöhung dar, wenn die Rauschunterdrückung auf Interkanalmodulation beruht. Bei einem Nutzsignal bleibt Zustand 4 erhalten. Es ist zu sehen, daß bei einer interkanalmodulationsbedingten Rauschunterdrückung der Zustand 5 durch Speicherung beibehalten werden muß. Die Verringerung des Oszillatorpegels P auf den kleineren Wert erfolgt, wenn der logische Wert A am Ausgang des Schwellwertschalters bei Unterschreiten des Grenzwertes wieder O wird (zum Beispiel Zustand 6). Zur Überprüfung der Kriterien wird der Funkempfänger vorzugsweise zyklisch in den Normalbetrieb zurückgesetzt. Die Speicherung und die zeitliche Steuerung kann beispielsweise durch die Mikroprozessorschaltung 30 erfolgen. Die zeitliche Steuerung kann gegebenenfalls auch ein Zeitkreis übernehmen.

Anstelle der in der Zeichnung mit 22 bezeichneten Rauschsperre kann auch eine andere Vorrichtung zur Ermittlung des Rauschkriteriums treten.

## Patentansprüche

1. Batterie- oder akkumulatorbetriebener Funkempfänger, der ein Hochfrequenzteil, einen Mischer mit Oszillator und ein Zwischenfrequenzteil mit Rauschsperre aufweist, dadurch gekennzeichnet, daß die von dem Oszillator (25) abgegebene Oszillatorspannung ($U_0$) von einem normalen Wert ($U_{01}$) auf einen höheren Wert ($U_{02}$) angehoben wird, wenn die Empfangssignalspannung ($U_E$) einen bestimmten Wert überschreitet und wenn gleichzeitig die Rauschsperre (22) eine Schaltspannung abgibt.

2. Funkempfänger nach Anspruch 1, dadurch gekennzeichnet, daß eine logische Verknüpfungsschaltung (21) vorgesehen ist, deren einer Eingang (20) über einen Schwellwertschalter (19) mit einem die Empfangssignalspannung ($U_E$) aufweisenden Schaltungspunkt (18) des Hochfrequenzteils, deren anderer Eingang (23) mit dem Ausgang der Rauschsperre (22) und deren Ausgang (24) mit einem Oszillatorverstärker (26) zum Erhöhen der Oszillatorspannung ($U_0$) verbunden ist.

3. Funkempfänger nach Anspruch 1 oder 2, dadurch gekennzeichnet, daß eine Mikroprozessorschaltung (30) oder ein Zeitkreis vorgesehen ist, der den Oszillatorpegel in zyklischen Zeitabständen auf den normalen Oszillatorpegel ($U_{01}$) zurückschaltet.

## Claims

1. A battery- or accumulator-operated radio receiver, which has a high-frequency section, a mixer having an oscillator, and an intermediate-frequency section having a muting device, characterised in that the voltage ($U_0$) delivered by the oscillator (25) is increased from a normal value ($U_{01}$) to a higher value ($U_{02}$) if the receiver signal voltage ($U_E$) exceeds a particular value and the muting device (22) simultaneously delivers a switching voltage.

2. A radio receiver as claimed in claim 1, characterised in that a logical switching circuit (21) is provided, one input (20) of which is connected by way of a threshold switch (19) to a switching point (18) of the high-frequency section, the other input (23) being connected to the output of the muting device (22), and its output (24) to an oscillator amplifier (26) for increasing the oscillator voltage ($U_0$).

3. A radio receiver as claimed in claim 1 or 2, characterised in that a microprocessor circuit (30) or timing circuit is provided which switches the oscillator level back to the normal oscillator level ($U_{01}$) at cyclical intervals of time.

## Revendications

1. Récepteur radio fonctionnant sur batterie ou accumulateur, récepteur comportant une partie haute fréquence, un mélangeur avec oscillateur et une partie de fréquence intermédiaire avec silencieux, récepteur caractérisé en ce que la tension oscillatoire ($U_0$) délivrée par l'oscillateur (25) est portée d'une valeur normale ($U_{01}$) à une valeur plus élevée ($U_{02}$) lorsque la tension du signal de réception ($U_2$) dépasse une valeur déterminé et que simultanément le silencieux (22) délivre une tension de commulation.

2. Récepteur radio selon la revendication 1, caractérisé en ce qu'il est prévu un circuit de combinaison logique (21), dont une entrée (20) est reliée, par l'intermédiaire d'un commutateur à valeur de seuil (19), à un point de commutation (18) présentant la tension du signal de réception ($U_2$), de la partie haute fréquence, l'autre entrée (23) étant reliée à la sortie (24) de ce circuit (21) étant reliée à un amplificateur (26) pour augmenter la tension oscillatoire ($U_0$).

3. Récepteur radio selon la revendication 1 ou la revendication 2, caractérisé en ce qu'il est prévu un circuit microprocesseur (30) ou un circuit de synchronisation qui, à des intervalles de temps cycliques, ramène le niveau d'oscillation à sa valeur normale ($U_{01}$).